# EUROPEAN PATENT SPECIFICATION

(11) **EP 1 906 193 B1**
(45) Date of publication and mention of the grant of the patent: **27.11.2019**
(21) Application number: 06757391.5
(22) Date of filing: 16.06.2006
(51) Int. Cl.: G01R 31/367

(54) **METHOD AND DEVICE FOR DETECTING CHARGED STATE OF BATTERY**
VERFAHREN UND EINRICHTUNG ZUM ERKENNEN DES LADUNGSZUSTANDS EINER BATTERIE
PROCÉDÉ ET DISPOSITIF POUR DÉTECTER L'ÉTAT DE CHARGE DE LA BATTERIE

(30) Priority: 15.07.2005 JP 2005206891
(43) Date of publication of application: 02.04.2008
(73) Proprietor: The Furukawa Electric Co., Ltd., Chiyoda-ku Tokyo 100-8322 (JP)
(72) Inventor: IWAHANA, Fumikazu, Tokyo 100-8322 (JP); SATO, Toshiyuki, Tokyo 100-8322 (JP); KIMURA, Atsushi, Tokyo 100-8322 (JP); IIJIMA, Takashi, Tokyo 100-8322 (JP); WATANABE, Yuichi, Tokyo 100-8322 (JP)
(74) Representative: advotec.
(86) International application number: PCT/JP2006/312168
(87) International publication number: WO 2007/010691

(56) References cited:
- CN-A- 1 431 521
- JP-A- 2004 152 755
- JP-A- 2004 354 050
- US-A1- 2004 128 086
- US-A1- 2004 145 186
- US-A1- 2006 113 959

## Description

### TECHNICAL FIELD

The present invention relates to a method for detecting a battery state of charge and a battery state-of-charge detecting apparatus. More particularly, the present invention relates to a method and an apparatus for detecting a battery state of charge based on a measured open circuit voltage.

### TECHNICAL FIELD

There has been known a method for detecting a battery state of charge (SOC), including measuring an open circuit voltage (OCV) of a battery in a stable state and substituting the measured value into a relational expression of OCV and SOC to calculate an SOC.

For example, the following patent document 1 discloses the proportionality relation between OCV and SOC, and measurement of OCV enables detection of an SOC.

Patent document 1: Japanese Laid-open patent publication No. 2004-530880

CN1431521A discloses a Lithium-ion battery power measuring method and apparatus where impedance is measured using low frequency alternating current, and based on the measured impedance, a SOC-OCV curve is selected which, using the measured OCV, gives an estimation for the SOC.

US 2004/0145186 A1 discloses a power generation system and method, where a battery is charged by a generator, where an initial state of charge of the battery is determined by measuring the internal impedance of the battery, and where the state of charge during charging is determined by integrating the charge current.

US 2004/0128086 A1 discloses a system for determining the amount of charge of a battery by measuring OCV in a stable, passive state of the battery, by determining the initial SOC from the measured OCV, and by determining the state of charge during charging by integrating the charge current and incrementing the initial SOC using the integration result.

### DISCLOSURE OF THE INENTION

### PROBLEMS TO BE SOLVED BY THE INVENTION

However, the SOC-OCV relation of a battery varies as the battery is deteriorating. As time duration of use of the battery is longer, the error between an actual SOC and an SOC obtained by the relational expression of OCV and SOC becomes larger.

When such a detection error is caused, the calculated battery remaining amount is sometimes smaller than the actual battery remaining amount, this may cause such a problem that an optical output can not be obtained from a battery used in a vehicle power supply system when necessary.

Therefore, the present invention has an object to provide a method and an apparatus for detecting a battery state of charge precisely regardless of the deterioration state of a battery.

### MEANS FOR SOLVING THE PROBLEMS

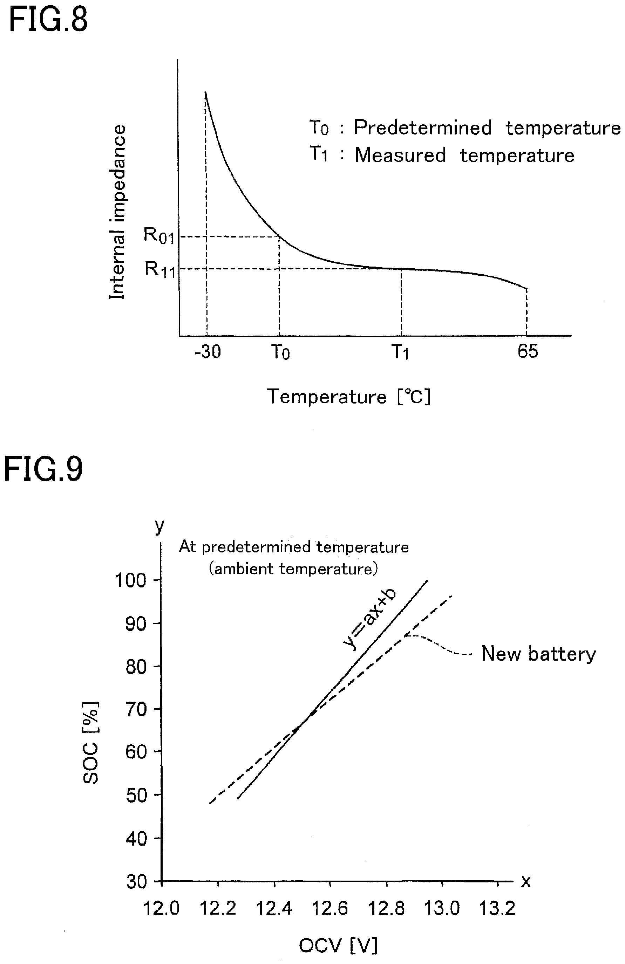

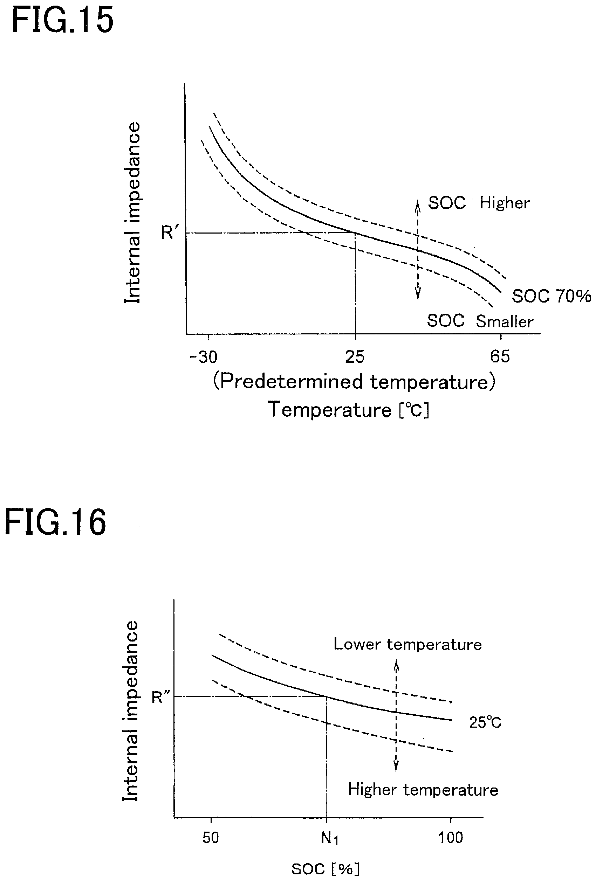

A method for detecting a state of charge of a battery according to the present invention is a method including the steps of:
Measuring an internal impedance (R11) of the battery (1);
measuring temperature (T1) of the battery (1) at the time of measuring the internal impedance (R11);
correcting the measured internal impedance (R11) to a corrected internal impedance (R01) at a predetermined temperature (T0) based on a previously obtained relation (Figs. 8, 15) between the internal impedance and temperature;
changing a coefficient (gradient a) and a constant (intercept b) of a SOC-OCV-function showing a relation (SOC=f(OCV)) between a stable-state voltage (OCV) and the state of charge (SOC) of the battery (1) in accordance with the corrected internal impedance (R01);
measuring the stable-state voltage (OCV) of the battery (1); and determining the state of charge (SOC) of the battery (1) by inserting the measured stable-state voltage (OCV) into the changed SOC-OCV-function showing the relation (SOC=f(OCV)) between the stable-state voltage (OCV) and the state of charge (SOC).

A second aspect of the method for detecting a state of charge of a battery is a method in which the step of obtaining the state of charge is performed by substituting the corrected stable-state voltage into a function showing a relation between the stable-state voltage and the state of charge.

A third aspect of the method for detecting a state of charge of a battery is a method including the steps of: measuring an internal impedance of the battery; measuring a stable-state voltage of the battery; and obtaining the state of charge of the battery by substituting the corrected stable-state voltage into a function showing a relation between the stable-state voltage and the state of charge.

Another aspect of the method for detecting a state of charge of a battery is a method in which the function is a linear function.

Another aspect of the method for detecting a state of charge of a battery is a method in which, assuming the state of charge is y and the stable-state voltage is x, the linear function is expressed by y = ax + b (where a is the coefficient and b is the constant).

Another aspect of the method for detecting a state of charge of a battery is a method including: the steps of: measuring an internal impedance of the battery; measuring a stable-state voltage of the battery; preparing matrix data showing relations between internal impedances and stable-state voltages respectively associated with plurally divided ranges of the state of charge; and obtaining the state of charge corresponding to one of the ranges which includes the internal impedance and the stable-state voltage.

Another aspect of the method for detecting a state of charge of a battery is a method further including: after the step of measuring the internal impedance, the step of measuring a temperature at a time when the internal impedance is measured, and the internal impedance used in the step of obtaining the state of charge being an internal impedance of a predetermined temperature corrected based on a previously obtained relation between the internal impedance and the temperature.

Another aspect of the method for detecting a state of charge of a battery is a method further including: after the step of measuring the internal impedance, the step of measuring a temperature at a time when the internal impedance is measured; after the step of obtaining the state of charge, the step of correcting the internal impedance to a corrected internal impedance of a predetermined temperature corrected based on a previously obtained relation between the internal impedance and the temperature; and obtaining the state of charge corresponding to one of the ranges which includes the corrected internal impedance and the stable-state voltage.

A battery state-of-charge detecting apparatus according to the present invention is a battery state-of-charge detecting apparatus having:
An internal impedance measuring unit (11) for measuring an internal impedance (R11) of a battery (1);
a temperature measuring unit (5) for measuring temperature (T1) of the battery (1) simultaneously with the impedance measurement by the impedance measuring unit (11);
a voltage measuring unit (12) for measuring a stable-state voltage (OCV) of the battery (1);
an internal impedance correcting unit (21) for correcting the internal impedance (R11) measured by the internal impedance measuring unit (11) to a corrected internal impedance (R01) at a predetermined temperature (T0) based on a previously obtained relation (Figs. 8, 15) between the internal impedance and the temperature;
a coefficient setting unit for changing a coefficient (gradient a) and a constant (intercept b) of a SOC-OCV-function showing a relation (SOC=f(OCV)) between a stable-state voltage (OCV) and the state of charge (SOC) of the battery (1) in accordance with the corrected internal impedance (R01); and
a state-of-charge calculating unit for calculating out the state of charge (SOC) of the battery (1) by inserting the stable-state voltage (OCV) measured by the voltage measuring unit (12) into the SOC-OCV-function changed by the coefficient setting unit.

A second aspect of the battery state-of-charge detecting apparatus is a battery state-of-charge detecting apparatus in which the state-of-charge calculating unit obtains the state of charge by substituting the internal impedance measured by the internal impedance measuring unit into a function showing a relation between the stable-state voltage and the state of charge.

A third aspect of the battery state-of-charge detecting apparatus is a battery state-of-charge detecting apparatus having: internal impedance measuring unit for measuring an internal impedance of a battery; voltage measuring unit for measuring a stable-state voltage of the battery; and state-of-charge calculating unit for obtaining a state of charge of the battery by substituting the internal impedance measured by the internal impedance measuring unit into a function showing a relation between the stable-state voltage and the state of charge.

Another aspect of the battery state-of-charge detecting apparatus is a battery state-of-charge detecting apparatus in which the function is a linear function.

Another aspect of the battery state-of-charge detecting apparatus is a battery state-of-charge detecting apparatus in which, assuming the state of charge is y and the stable-state voltage is x, the linear function is expressed by y = ax + b (where a is the coefficient and b is the constant) .

Another aspect of the battery state-of-charge detecting apparatus is a battery state-of-charge detecting apparatus having: internal impedance measuring unit for measuring an internal impedance of a battery; voltage measuring unit for measuring a stable-state voltage of the battery; data memory for storing matrix data showing relations between internal impedances and stable-state voltages as respectively associated with plurally divided ranges of the state of charge; and state-of-charge calculating unit for calculating out a state of charge by obtaining one of the ranges that corresponds to matrix data including the internal impedance measured by the internal impedance measuring unit and the stable-state voltage measured by the voltage measuring unit.

Another aspect of the battery state-of-charge detecting apparatus is a battery state-of-charge detecting apparatus in which the internal impedance measuring unit corrects the internal impedance measured by the internal impedance measuring unit, based on a temperature of the battery, to output a corrected internal impedance of a predetermined temperature.

Another aspect of the battery state-of-charge detecting apparatus is a batter state-of-charge detecting apparatus in which the internal impedance measuring unit corrects the corrected internal impedance of the predetermined temperature based on the state of charge calculated by the state-of-charge calculating unit to output a further corrected internal impedance.

Another aspect of the battery state-of-charge detecting apparatus is a battery state-of-charge detecting apparatus further including a temperature sensor attached to the battery for detecting the temperature of the battery to output temperature data to the internal impedance measuring unit.

### EFFECTS OF THE INVENTION

According to the present invention, a battery state of charge is detected by measuring an internal impedance and a battery stable-state voltage, correcting upward the battery stable-state voltage based on the internal impedance and calculating the state of charge based on the corrected voltage. As the internal impedance increased with the battery deteriorating is measured, it is possible to detect the battery state of charge precisely in accordance with deterioration of the battery.

In addition, according to the present invention, data of the relation between internal impedance and stable-state voltage of a battery is stored as matrix data and the matrix data is associated with corresponding one of plurally divided ranges of the state of charge. Then it is determined to which range of the battery state of charge a measured internal impedance and a measured battery stable-state voltage correspond, and a level defined for the determined range is detected as a state of charge level. This enables precise detection of a current level of the battery state of charge based on the internal impedance which varies as the battery deteriorates.

Furthermore, as the internal impedance varies by temperature of a battery, the temperature of the battery and the internal impedance are first measured, and the measured internal impedance is corrected to an internal impedance of a predetermined temperature. With this structure, it is possible to detect a state of charge more precisely.

As the internal impedance varies also by a state of charge of the battery, the battery state of charge is first detected, the internal impedance is corrected by the detected state of charge and the corrected internal impedance is used to obtain a battery state of charge, thereby enabling more precise detection of the battery state of charge.

### BRIEF DESCRIPTION OF THE DRAWINGS

Fig. 1 is a view illustrating a configuration of a battery state-of-charge detecting apparatus;
Fig. 2 is a graph showing the relation between state of charge and open circuit voltage of a battery targeted for detection by the battery state-of-charge detecting apparatus;
Fig. 3 is a graph showing an error between an actual measured state of charge and a state of charge obtained by calculation of the battery targeted for detection by the battery state-of-charge detecting apparatus;
Fig. 4 is a graph showing the relation between corrected internal impedance of a predetermined temperature and battery voltage during discharge of the battery targeted for detection by the battery state-of-charge detecting apparatus;
Fig. 5 is a graph showing the relation between internal impedance and open circuit voltage of the battery targeted for detection by the battery state-of-charge detecting apparatus;
Fig. 6 is a flowchart of a method for detecting a battery state of charge;
Fig. 7 is a view illustrating a configuration of a battery state-of-charge detecting apparatus according to the invention;
Fig. 8 is a graph showing the relation between temperature and internal impedance of the battery;
Fig. 9 is a graph showing an example of the relation between open circuit voltage and a state of charge of the battery;
Fig. 10 is a graph showing the relation between internal impedance at a predetermined temperature and open circuit voltage of the battery targeted for detection by the battery state-of-charge detecting apparatus according to the invention, in which the state of charge is shown as a parameter;
Fig. 11 is a graph showing the internal-impedance dependence of the gradient and the intercept of the linear function of the SOC-OCV relation of the battery targeted for detection by the battery state-of-charge detecting apparatus according to the invention;
Fig. 12 is a graph showing the linear function of the SOC-OCV relation set with use of the graph of Fig. 11 in the battery state-of-charge detecting apparatus according to the invention;
Fig. 13 is a graph showing an error between an actual measured state of charge and a state of charge obtained by calculation of the battery targeted for detection by the battery state-of-charge detecting apparatus according to the invention;
Fig. 14 is a flowchart of a method for detecting a battery state of charge according to the invention;
Fig. 15 is a graph showing the relation between internal impedance and temperature targeted for detection by the battery state-of-charge detecting apparatus or the method for detecting a battery state of charge according to the invention;
Fig. 16 is a graph showing the relation between internal impedance and state of charge targeted for detection by the battery state-of-charge detecting apparatus or the method for detecting a battery state of charge according to the embodiment;
Fig. 17 is a view illustrating a configuration of a battery state-of-charge detecting apparatus according to another embodiment;
Fig. 18 is a graph showing the relation between internal impedance and open circuit voltage of the battery targeted for detection by the battery state-of-charge detecting apparatus according to the embodiment, the graph showing the state of charge is divided into plural ranges and each of the ranges includes matrix data of internal impedances and open circuit voltages; and
Fig 19 is a flowchart of a method for detecting a battery state of charge according to the embodiment, showing a method for detecting an SOC with use of the graph of Fig. 18.

### DESCRIPTION OF SYMBOLS

- 1: battery
- 2: load
- 10: battery state-of-charge (SOC) detecting portion
- 11: internal impedance measuring unit
- 12: OCV measuring unit
- 13: OCV correcting unit
- 14: correction data memory
- 16: SOC calculating unit
- 17: SOC outputting unit
- 21: internal impedance correcting unit
- 25: coefficient setting unit
- 26: SOC-OCV characteristic memory
- 31: data memory
- 32: SOC level calculating unit
- 33: SOC level outputting unit

### BEST MODE FOR CARRYING OUT THE INVENTION

Based on the drawings, embodiments of the present invention will be described in detail below.

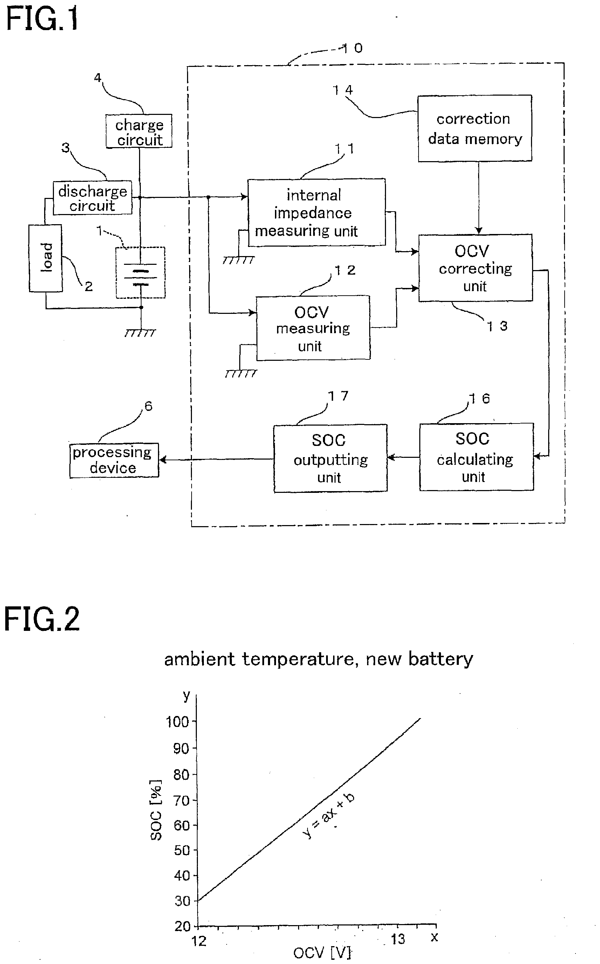

Fig. 1 is a view illustrating a battery state-of-charge detecting apparatus. In Fig. 1, a battery 1 is connected to a discharge circuit 3 for controlling a current supplied from the battery 1 to a load 2, a charge circuit 4 for charging power supply and a battery SOC detecting portion 10 for measuring a open-circuit state of charge.

The battery SOC detecting portion 10 includes internal impedance measuring unit 11 connected to positive and negative terminals of the battery 1 for measuring an internal impedance of the battery 1, OCV measuring unit 12 connected to both of the terminals of the battery 1 for measuring an OCV (Open Circuit Voltage), OCV correcting unit 13 for correcting the OCV output from the OCV measuring unit 12 based on the internal impedance output from the internal impedance measuring unit 11 to output a corrected OCV and SOC calculating unit 16 receiving the corrected OCV output from the OCV correcting unit to determine an SOC (State of Charge) of the battery 1. Here, the OCV is also referred to as stable-state voltage.

The OCV correcting unit 13 is configured to capture correction data stored in a correction data memory 14 and output a corrected OCV based on the correction data and the outputs from the internal impedance measuring unit 11 and the OCV measuring unit 12.

Besides, the OCV calculating unit 16 is configured to calculate an SOC by substituting the corrected OCV, which is output from the OCV correcting unit 13, into the function of SOC-OCV characteristic of the battery 1 in new conditions (also referred to as "new battery"), and to output a calculation result to a processing device 6 such as a display unit. Here, the SOC is expressed, for example, as 100 % when the battery is fully charged.

Next description is made about correction of an OCV by the OCV correcting unit 13. The SOC-OCV relation of the new battery 1 is expressed by the linear function such as shown in Fig. 2. In Fig. 2, when the SOC is y (%) and the OCV is x (V), such a relation that y = ax + b (a: coefficient (gradient), b: constant (intercept)) is established and the SOC is calculated by substituting an OCV of the battery 1 measured by the OCV measuring unit 12 into the function.

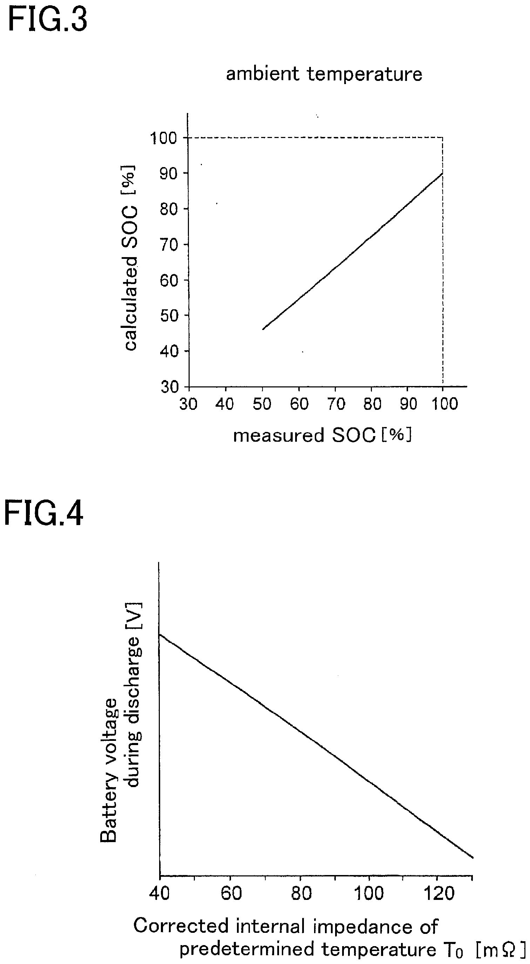

However, when the battery 1 deteriorates further, the SOC calculated by substituting the measured OCV into the function shown in Fig. 2 becomes different from an actual SOC. This causes an error, for example shown in Fig. 3, between the calculated SOC and the actual SOC.

Meanwhile, the battery 1 has properties such that the internal impedance is increased as the battery 1 is deteriorating and the increase of the internal impedance causes reduction of battery voltage during discharge, as illustrated in Fig. 4.

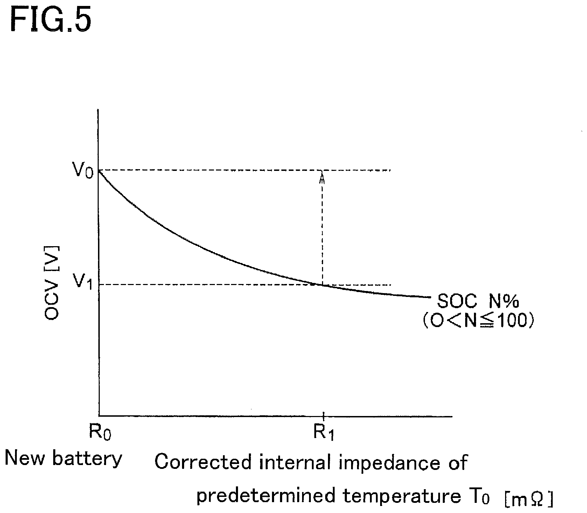

In addition, the relation between internal impedance and OCV of the battery 1 is as shown in Fig. 5 when the SOC is a parameter. In other words, even if an SOC of the new battery 1 and an SOC of the deteriorated battery 1 present an identical value N (0 < N ≤ 100), an OCV V₁ of the deteriorated battery 1 is lower than an OCV V₀ of the new battery 1, and an internal impedance R₁ of the deteriorated battery 1 is larger than an internal impedance R₀ of the new battery 1.

Accordingly, if the SOC of the deteriorated battery 1 is calculated by substituting the measured OCV as it is into the function shown in Fig. 2, the calculated SOC is different from an actual SOC. Hence, the relation between internal impedance and OCV and the measured internal impedance R₁ are used to correct the actual measured OCV V₁ of the deteriorated battery 1 upward to the OCV V₀ of the new battery 1, and then, the corrected value V₀ is substituted into the function shown in Fig. 2. This makes it possible to enhance detection accuracy of the SOC.

Then, an internal impedance of the new battery 1 is measured and associated with a function of SOC-OCV characteristic as shown in Fig. 2. Then, the relation between OCV and internal impedance with SOC set as a parameter is used to obtain a characteristic shown in Fig. 5 for each type of the battery 1, and thus obtained data or functions obtained based on the data are stored in the correction data memory 14.

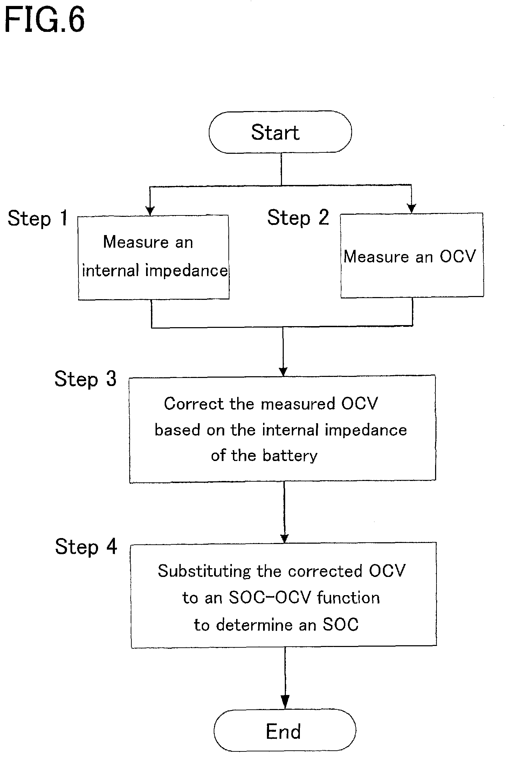

Next description is made about an SOC detecting method of the battery state-of-charge (SOC) detecting portion 10, with reference to the flowchart shown in Fig. 6.

First, the battery 1 targeted for SOC detection is connected to the battery state-of-charge detecting portion 10, and an internal impedance R₁ and an OCV V₁ measured by the internal impedance measuring unit 11 and the OCV measuring unit 12, respectively, are input to the OCV correcting unit 13 (Steps 1 and 2 in Fig. 6).

The OCV correcting unit 13 obtains from the data of the correction data memory 14, for example, data of the relation shown in Fig. 5, a value V₀ of the new battery obtained when the SOC is N% corresponding to the intersection between the values R₁ and V₁, and corrects the actual value V₁ upward to the value V₀ (Step 3 in Fig. 6). Here, correction of the OCV is not limited to this method, and for example, the actual internal impedance and the actual OCV of the battery 1 may be used as a basis to correct the actual OCV into the OCV of the new battery.

The thus-corrected OCV is output from the OCV correcting unit 13 to the SOC calculating unit 16. After receiving the corrected OCV, the SOC calculating unit 16 substitutes the corrected OCV into the linear function such as shown in Fig. 2 to calculate an SOC as N% (Step 4 in Fig 6), and outputs the calculated SOC to the SOC outputting unit 17. The calculated SOC N% is output from the SOC outputting unit 17 to the processing device 6.

With this structure, it is possible to detect an SOC with high precision regardless of the degree of deterioration of the battery 1.

### (embodiment)

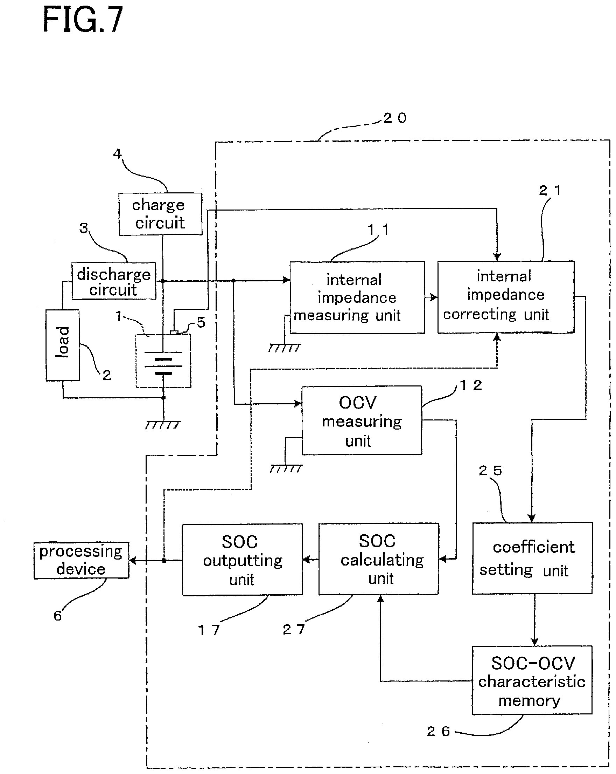

Fig. 7 is a view illustrating a battery state-of-charge detecting apparatus according the embodiment. In Fig. 7, the same reference numerals as those in Fig. 1 denote the same elements.

In Fig. 7, a battery state-of-charge detecting portion 20 has: internal impedance measuring unit 11 connected to the both terminals of the battery 1 for measuring an internal impedance of the battery 1 to output the measured data; OCV measuring unit 12 for measuring an open circuit voltage (OCV) between both terminals of the battery 1 to output the measured data; an SOC-OCV characteristic memory 26 for storing a program for calculation based on the function of the SOC-OCV characteristic of the battery 1; SOC calculating unit 27 for capturing the program from the SOC-OCV characteristic memory 26 and running the program with use of the measured OCV received from the OCV measuring unit 12 to calculate an SOC; and SOC outputting unit 17 for outputting the calculated SOC, output from the SOC calculating unit 27, to a processing device 6 such as display unit.

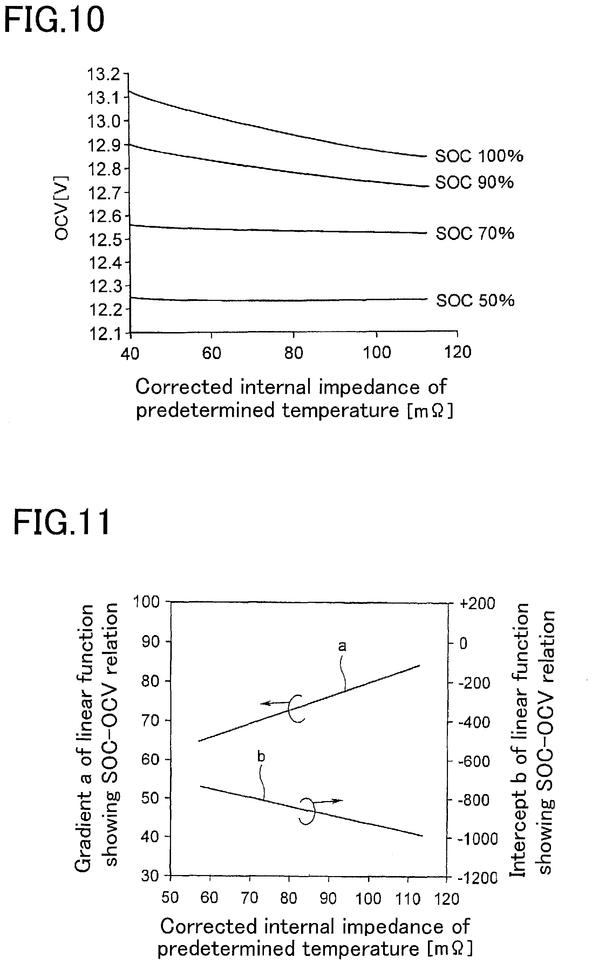

Further, the internal impedance measuring unit 11 has an output terminal connected to internal impedance correcting unit 21 for correcting an actual measured internal impedance of the battery 1 having temperature dependence shown in Fig. 11 to an internal impedance of a predetermined temperature. The internal impedance correcting unit 21 receives a temperature measured by a temperature sensor 5 attached to the battery 1 and the actual measured internal impedance measured by the internal impedance measuring unit 11, and corrects the actual measured internal impedance R₁₁ at the actual measured temperature T₁ of the battery 1 into an internal impedance R₀₁ of a predetermined temperature T₀ by use of the relation shown in Fig. 8 to output the corrected value to coefficient setting unit 25. The temperature used as a predetermined temperature T₀ is for example, a room temperature, an ambient temperature, or a lower or higher predetermined temperature.

Connected to between the internal impedance correcting unit 21 and the SOC-OCV characteristic memory 26 is the coefficient setting unit 25 for setting a coefficient and a constant of the function stored in the SOC-OCV characteristic memory 26. When the function stored in the SOC-OCV characteristic memory 26 is a linear function expressed by y = ax + b, for example, the coefficient setting unit 25 changes the gradient a and the intercept b in accordance with the internal impedance output from the internal impedance correcting unit 21. The gradient a and the intercept b are changed for the reason described below.

The SCO-OCV characteristic of the new battery is expressed by the broken line in Fig. 9. However, the SCO-OCV characteristic of the deteriorating battery varies as indicated by the solid line in Fig. 9, and the gradient a and the intercept b of the linear function y = ax + b are changed. If changes of the gradient a and the intercept b with deterioration of the battery 1 can be predicted, it is possible to obtain a precise SOC-OCV characteristic of the deteriorating battery 1 and thereby to obtain a precise SOC based on the actual measured OCV.

In addition the SOC-OCV relation is changed with deterioration of the battery 1, that is, changes in internal impedance. The relation between OCV and internal impedance of the battery 1 obtained by actual measurement for each SOC of 100%, 90%, 70% and 50% is such as shown in Fig. 10, which shows that even if the SOC is the same, the OCV becomes lower with increasing internal impedance. Here, the internal impedance in Fig. 10 is a corrected value of a predetermined temperature.

Further, the SOC-OCV relation and the internal impedance shown in Fig. 10 are used as a basis to obtain the gradient a and the intercept b for each internal impedance, which is shown in Fig. 11.

Thus, in order to calculate an SOC precisely based on the actual measured internal impedance and the actual measured OCV, it is necessary to arrange the function of SOC-OCV relation of the targeted battery 1 in accordance with deterioration level of the battery 1.

For example, when the actual measured impedance of the battery 1 at the predetermined temperature is 110 mQ and the actual measured OCV is 12.72V, the SOC is 90% according to the graph of Fig. 10. However, when the actual measured OCV 12.72 is applied to the function expressed by the broken line in Fig. 9, the SOC is 75% and there occurs a large error of about 15% between the actual SOC and the SOC of the new battery 1.

Then, the coefficient and constant of the SOC-OCV characteristic are changed with changes in the internal impedance of the battery 1, thereby to make the SOC value obtained by the function conform to the actual-measurement SOC.

For example, when the linear function showing the OCV(x)-SOC(y) relation indicated by the solid line in Fig. 9 is y = ax + b, the relation between the gradient a and the internal impedance can be expressed by the linear function of Fa(x') = Ax' + B as indicated by a in Fig. 11, while the relation between the intercept b and the internal impedance can be expressed by the linear function Fb(x') = Cx' + D as indicated by b in Fig. 11. Here, x' is a value of internal impedance, A and C are coefficients, and B and D are constants, and they vary dependent on the structure of the battery 1.

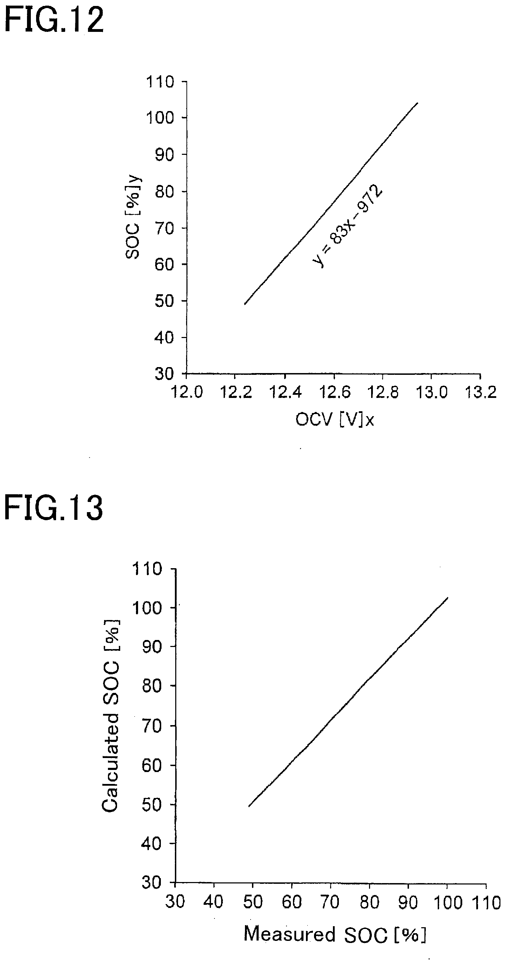

According to the example in Fig. 11, the real measured internal impedance x' is 110 mQ, the gradient Fa(x') = 83 and the intercept Fb(x') = -972, the linear function of this SOC-OCV relation is as shown in Fig. 12 and the expression of this linear function is y = 83x - 972. Hence, when x indicative of the OCV is 12.85V, y indicative of the SOC is about 100%, which conform to the result shown in Fig. 10. In addition, the gradient and intercept of the function of the SOC-OCV characteristic is determined based on the actual measured internal impedance and the SOC calculated by the function and the actual measured SOC are compared, which result is shown in Fig. 13. In Fig. 13, the calculated SOC and the actual measured SOC are found to be almost in good agreement. This shows that the SOC can be calculated with high accuracy based on the actual measured internal impedance and OCV.

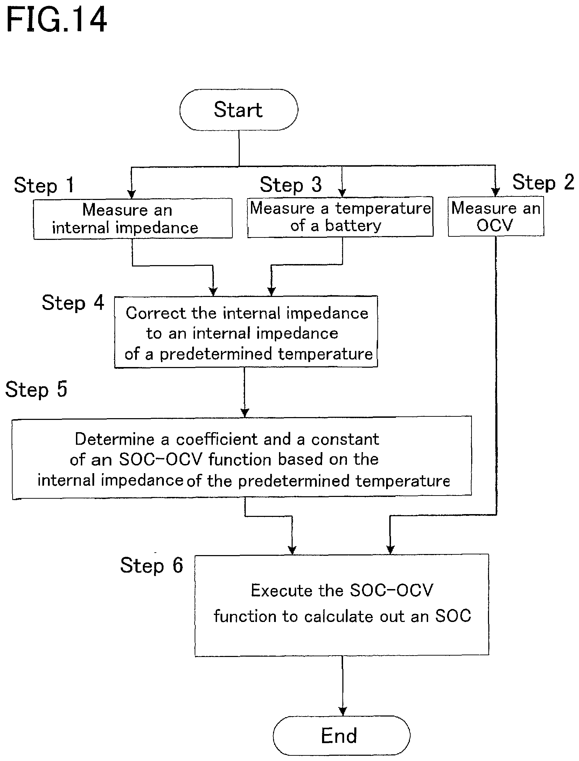

The above-described method for detecting a state of charge of the battery 1 by the state-of-charge detecting portion 20 is explained with reference to the flowchart in Fig. 14.

First, when the battery 1 is in an open circuit state, the internal impedance measuring unit 11 is used to measure an internal impedance of the battery 1 and the OCV measuring unit 12 is used to measure an open circuit voltage (OCV) of the battery 1, and the temperature sensor 5 is used to measure a temperature of the battery 1 (Steps 1 to 3 in Fig. 14)

The internal impedance R₁₁ and the temperature T₁ measured by the internal impedance measuring unit 11 and the temperature sensor 5, respectively, are output to the internal impedance correcting unit 21. Based on the characteristic shown in Fig. 8, the internal impedance correcting unit 21 corrects the actual measured internal impedance R₁₁ of the actual temperature T₁ to an internal impedance value R₀₁ of a predetermined temperature T₀ and outputs the corrected internal impedance R₀₁ to the coefficient setting unit 25 (Step 4 in Fig.14).

The coefficient setting unit 25 determines a gradient (coefficient) and an intercept (constant) of the linear function of the SOC-OCV characteristic in the SOC-OCV characteristic memory 26 based on the corrected internal impedance R₀₁ of the predetermined temperature T₀ (Step 5 in Fig. 14). The values of the gradient and intercept are determined, for example, with use of the function shown in Fig. 11.

Meanwhile, the SOC calculating unit 27 captures a program for execution of the function in the SOC-OCV characteristic memory 26 and runs the program based on the actual measured OCV output from the OCV measuring unit 12 to calculates an SOC (Step 5 in Fig. 14).

The coefficient and constant of the linear function of the SOC-OCV characteristic is not limited to those expressed by linear functions such as shown in Fig. 11 or may be expressed by another functions.

Here, the internal impedance of the battery 1 depends on not only the temperature but also the SOC value, as shown in Figs. 15 and 16. Fig. 15 shows the relation between internal impedance and temperature with the SOC as a parameter, while Fig. 16 shows the relation between SOC and internal impedance with the temperature as a parameter.

Accordingly, the internal impedance correcting unit 21 may be configured to not only change the internal impedance to that of the predetermined temperature but also change and correct the internal impedance further based on the SOC calculated by the SOC calculating unit 27.

For example, as shown by the broken line in the battery state-of-charge detecting portion 20 of Fig. 7, an output signal from the SOC calculating unit 27 may be input to the internal impedance correcting unit 21. In this configuration, the internal impedance correcting unit 21 corrects the internal impedance based on the actual measured temperature as well as a calculation result of the SOC calculating unit 27.

Hence, the internal impedance measured by the internal impedance measuring unit 11 is changed to an internal impedance R' of the predetermined temperature by the internal impedance correcting unit 21 and the internal impedance R' is further corrected to R" based on the SOC N₁. This enables more precise detection of the SOC.

Here, correction of the internal impedance based on the temperature and correction of the internal impedance based on both of the temperature and the SOC can be adopted in the third embodiments.

### (Other embodiment)

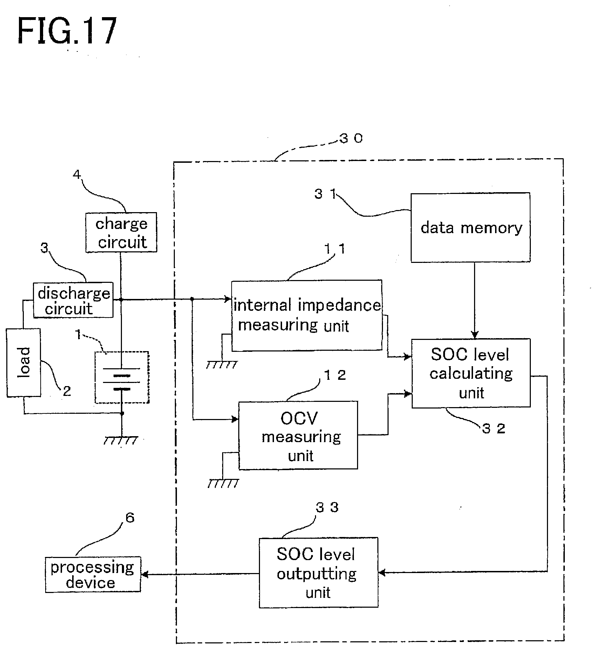

Fig. 17 is a view illustrating a battery state-of-charge detecting apparatus according to another embodiment, and the same reference numerals as in Fig. 1 denote the same elements.

In Fig. 17, a battery state-of-charge detecting portion 30 connected to the battery 1 has: internal impedance measuring unit 11 connected to the both terminals of the battery 1; OCV measuring unit 12 connected to the both terminals of the battery 1; a data memory 31 storing matrix data of internal impedances and OCVs of the battery 1 for each of plurally divide ranges of the SOC; SOC level calculating unit 32 capturing data stored in the date memory 31 and calculating an SOC level of the battery 1 based on measured data of the internal impedance measuring unit 11 and the OCV measuring unit 12; and SOC level outputting unit 33 for transmitting the SOC level calculated by the SOC level calculating unit 32 to an external processing device 6.

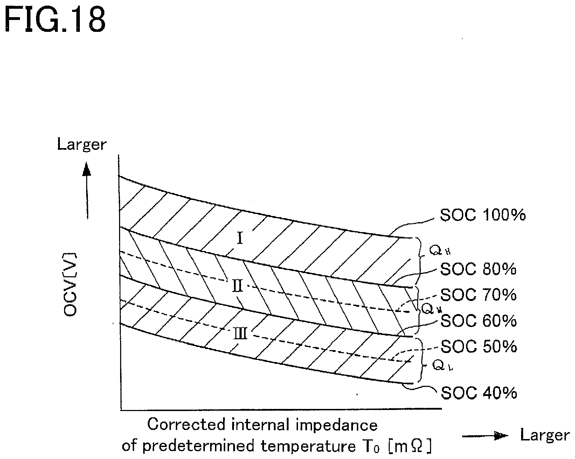

The data stored in the above-mentioned data memory 31 is, for example, matrix data shown in Fig. 18.

In Fig. 18, SOC values of the battery 1 are divided into three ranges of low range, middle range and high range, for example, a range of 40% or more to less than 60%, a range of 60% or more to less than 80% and a range of 80% to 100 inclusive. A large amount of data of actual measured internal impedances and actual measured OCVs is collected for each of the ranges of the battery 1 of from its new state to its deteriorated state and stored as matrix data per range.

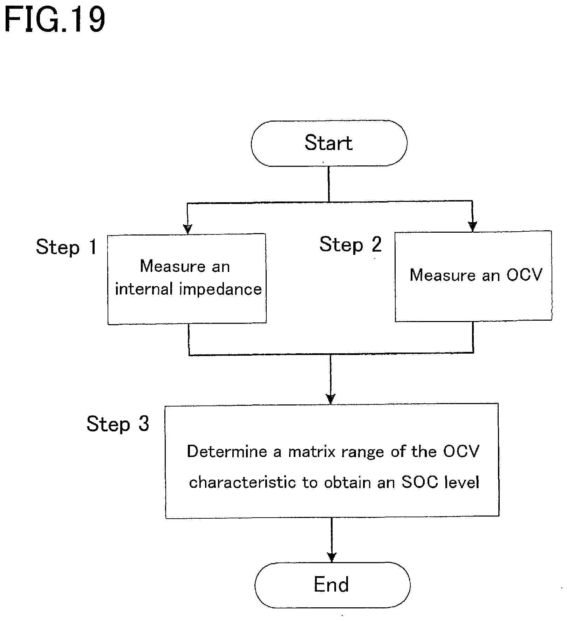

In order to detect an actual SOC of the battery 1, first, the internal impedance measuring unit 11 and the OCV measuring unit 12 measure an internal impedance and an OCV of the battery 1, respectively, and output the measured values to the SOC level calculating unit 32 (Steps 1 and 2 in Fig. 19).

Next, the SOC level calculating unit 32 checks the measured internal impedance and OCV against matrix data in the data memory 31. When the measured internal impedance and OCV are plotted in the high level range I, the SOC level calculating unit 32 calculates out the SOC as a high value Q_{H}. When the measured internal impedance and OCV are plotted in the middle level range II, the SOC level calculating unit 32 calculates out the SOC as a middle value Q_{M}. When the measured internal impedance and OCV are plotted in the low level range III, the SOC level calculating unit 32 calculates out the SOC as a low value Q_{L}. Then, the calculated value is output to the SOC level outputting unit 33 (Step 3 in Fig. 19).

With this configuration, it is possible to display the SOC of the battery 1 as a state level such as low state of charge, middle state of charge or high state of charge, instead of a specific charge rate.

## Claims

1. A method for detecting a state of charge (SOC) of a battery (1), comprising the steps of:
measuring an internal impedance (R₁₁) of the battery (1);
measuring temperature (T₁) of the battery (1) at the time of measuring the internal impedance (R₁₁);
correcting the measured internal impedance (R₁₁) to a corrected internal impedance (R₀₁) at a predetermined temperature (T₀) based on a previously obtained relation (Figs. 8, 15) between the internal impedance and temperature;
changing a coefficient (gradient a) and a constant (intercept b) of a SOC-OCV-function showing a relation (*SOC*=*f(OCV)*) between a stable-state voltage (OCV) and the state of charge (SOC) of the battery (1) in accordance with the corrected internal impedance (R₀₁);
measuring the stable-state voltage (OCV) of the battery (1); and
determining the state of charge (SOC) of the battery (1) by inserting the measured stable-state voltage (OCV) into the changed SOC-OCV-function showing the relation (*SOC*=*f(OCV)*) between the stable-state voltage (OCV) and the state of charge (SOC).

2. The method of 1, wherein the SOC-OCV-function is a linear function.

3. The method of claim 2, wherein, assuming the state of charge (SOC) is y and the stable-state voltage (OCV) is x, the linear SOC-OCV-function is expressed by y = ax + b (where a is the coefficient and b is the constant).

4. A battery state-of-charge detecting apparatus comprising:
an internal impedance measuring unit (11) for measuring an internal impedance (R₁₁) of a battery (1);
a temperature measuring unit (5) for measuring temperature (T₁) of the battery (1) simultaneously with the impedance measurement by the impedance measuring unit (11);
a voltage measuring unit (12) for measuring a stable-state voltage (OCV) of the battery (1);
an internal impedance correcting unit (21) for correcting the internal impedance (R₁₁) measured by the internal impedance measuring unit (11) to a corrected internal impedance (R₀₁) at a predetermined temperature (T₀) based on a previously obtained relation (Figs. 8, 15) between the internal impedance and the temperature;
a coefficient setting unit for changing a coefficient (gradient a) and a constant (intercept b) of a SOC-OCV-function showing a relation (*SOC*=*f(OCV)*) between a stable-state voltage (OCV) and the state of charge (SOC) of the battery (1) in accordance with the corrected internal impedance (R₀₁); and
a state-of-charge calculating unit for calculating out the state of charge (SOC) of the battery (1) by inserting the stable-state voltage (OCV) measured by the voltage measuring unit (12) into the SOC-OCV-function changed by the coefficient setting unit.

5. The battery state-of-charge detecting apparatus of claim 4, wherein the SOC-OCV-function is a linear function.

6. The battery state-of-charge detecting apparatus of claim 5, wherein, assuming the state of charge (SOC) is y and the stable-state voltage (OCV) is x, the linear SOC-OCV-function is expressed by y = ax + b (where a is the coefficient and b is the constant).

7. The battery state-of-charge detecting apparatus of any one of claims 4 to 6, wherein the internal impedance measuring unit (11) corrects the corrected internal impedance (R') of the predetermined temperature (T₀) based on the state of charge (SOC) calculated by the state-of-charge calculating unit to output a further corrected internal impedance (R").

8. The battery state-of-charge detecting apparatus of any one of claims 4 to 7, further comprising a temperature sensor (5) attached to the battery (1) for detecting the temperature (T₁) of the battery (1) to output temperature data to the internal impedance measuring unit (11).

## Patentansprüche

1. Verfahren zur Erkennung eines Ladezustands (SOC) eines Akkus (1), wobei das Verfahren folgende Schritte umfasst:
Messen eines Innenwiderstands (R₁₁) des Akkus (1);
Messen der Temperatur (T₁) des Akkus (1) zum Zeitpunkt des Messens des Innenwiderstands (R₁₁);
Korrigieren des gemessenen Innenwiderstands (R₁₁) auf einen korrigierten Innenwiderstand (R₀₁) bei einer vorbestimmten Temperatur (T₀) auf Basis einer zuvor ermittelten Relation (Fig. 8, Fig. 15) zwischen dem Innenwiderstand und der Temperatur;
Verändern eines Koeffizienten (Gradient a) und einer Konstanten (Achsenabschnitt b) einer SOC-OCV-Funktion, die eine Relation (*SOC*=*f(OCV)*) zwischen einer Leerlaufspannung (OCV) und dem Ladezustand (SOC) des Akkus (1) in Abhängigkeit von dem korrigierten Innenwiderstand (R₀₁) zeigt;
Messen der Leerlaufspannung (OCV) des Akkus (1); und
Bestimmen des Ladezustands (SOC) des Akkus (1) durch Einsetzen der gemessenen Leerlaufspannung (OCV) in die veränderte SOC-OCV-Funktion, welche die Relation (*SOC*=*f(OCV)*) zwischen der Leerlaufspannung (OCV) und dem Ladezustand (SOC) zeigt.

2. Verfahren nach Anspruch 1, wobei die SOC-OCV-Funktion eine lineare Funktion ist.

3. Verfahren nach Anspruch 2, wobei, wenn der Ladezustand (SOC) y ist und die Leerlaufspannung (OCV) x ist, die lineare SOC-OCV-Funktion durch y = ax + b ausgedrückt ist (wobei a der Koeffizient und b die Konstante ist).

4. Akkuladezustandserkennungsvorrichtung, umfassend:
eine Innenwiderstandsmesseinheit (11) zum Messen eines Innenwiderstands (R₁₁) eines Akkus (1);
eine Temperturmesseinheit (5) zum Messen der Temperatur (T₁) des Akkus (1) gleichzeitig zur Widerstandsmessung durch die Widerstandsmesseinheit (11);
eine Spannungsmesseinheit (12) zum Messen einer Leerlaufspannung (OCV) des Akkus (1);
eine Innenwiderstandskorrektureinheit (21) zum Korrigieren des von der Innenwiderstandsmesseinheit (11) gemessenen Innenwiderstands (R₁₁) auf einen korrigierten Innenwiderstand (R₀₁) bei einer vorbestimmten Temperatur (T₀) auf Basis einer zuvor ermittelten Relation (Fig. 8, Fig. 15) zwischen dem Innenwiderstand und der Temperatur;
eine Koeffizienteneinstellungseinheit zum Verändern eines Koeffizienten (Gradient a) und einer Konstanten (Achsenabschnitt b) einer SOC-OCV-Funktion, die eine Relation (*SOC*=*f(OCV)*) zwischen einer Leerlaufspannung (OCV) und dem Ladezustand (SOC) des Akkus (1) in Abhängigkeit von dem korrigierten Innenwiderstand (R₀₁) zeigt; und
eine Ladezustandsberechnungseinheit zum Berechnen des Ladezustands (SOC) des Akkus (1) durch Einsetzen der durch die Spannungsmesseinheit (12) gemessenen Leerlaufspannung (OCV) in die durch die Koeffizienteneinstellungseinheit veränderte SOC-OCV-Funktion.

5. Akkuladezustandserkennungsvorrichtung nach Anspruch 4, wobei die SOC-OCV-Funktion eine lineare Funktion ist.

6. Akkuladezustandserkennungsvorrichtung nach Anspruch 5, wobei, wenn der Ladezustand (SOC) y ist und die Leerlaufspannung (OCV) x ist, die lineare SOC-OCV-Funktion durch y = ax + b ausgedrückt ist (wobei a der Koeffizient und b die Konstante ist).

7. Akkuladezustandserkennungsvorrichtung nach einem der Ansprüche 4 bis 6, wobei die Innenwiderstandsmesseinheit (11) den korrigierten Innenwiderstand (R') der vorbestimmten Temperatur (T₀) auf Basis des durch die Ladezustandsberechnungseinheit berechneten Ladezustands (SOC) korrigiert, um einen weiteren korrigierten Innenwiderstand (R") auszugeben.

8. Akkuladezustandserkennungsvorrichtung nach einem der Ansprüche 4 bis 7, des Weiteren umfassend einen Temperatursensor (5), der zur Erkennung der Temperatur (T₁) des Akkus (1) an dem Akku (1) angebracht ist, um Temperaturdaten an die Innenwiderstandsmesseinheit (11) auszugeben.

## Revendications

1. Procédé de détection d'un état de charge (SOC) d'une batterie (1), le procédé comprenant les étapes consistant à :
mesurer une impédance interne (R₁₁) de la batterie (1) ;
mesurer la température (T₁) de la batterie (1) au moment de la mesure de l'impédance interne (R₁₁) ;
corriger l'impédance interne (R₁₁) mesurée à une impédance interne corrigée (R₀₁) à une température prédéterminée (T₀) sur la base d'une relation (Fig. 8, Fig. 15) obtenue précédemment entre l'impédance interne et la température ;
changer un coefficient (pente a) et une constante (ordonnée à l'origine b) d'une fonction SOC-OCV présentant une relation (*SOC*=*f(OCV)*) entre une tension en circuit ouvert (OCV) et l'état de charge (SOC) de la batterie (1) en fonction de l'impédance interne corrigée (R₀₁) ;
mesurer la tension en circuit ouvert (OCV) de la batterie (1) ; et
déterminer l'état de charge (SOC) de la batterie (1) en insérant la tension en circuit ouvert (OCV) mesurée dans la fonction SOC-OCV changée présentant la relation (*SOC*=*f(OCV)*) entre la tension en circuit ouvert (OCV) et l'état de charge (SOC).

2. Procédé selon la revendication 1, dans lequel la fonction SOC-OCV est une fonction linéaire.

3. Procédé selon la revendication 2, dans lequel, lorsque l'état de charge (SOC) est y et la tension en circuit ouvert (OCV) est x, la fonction linéaire SOC-OCV est exprimée par y = ax + b (où a est le coefficient et b est la constante).

4. Dispositif pour détecter un état de charge d'une batterie, le dispositif comprenant :
une unité de mesure d'impédance interne (11) destinée à mesurer une impédance interne (R₁₁) d'une batterie (1) ;
une unité de mesure de température (5) destinée à mesurer la température (T₁) de la batterie (1) simultanément avec la mesure de l'impédance par l'unité de mesure d'impédance (11) ;
une unité de mesure de tension (12) destinée à mesurer une tension en circuit ouvert (OCV) de la batterie (1) ;
une unité de correction d'impédance interne (21) destinée à corriger l'impédance interne (R₁₁) mesurée par l'unité de mesure d'impédance interne (11) à une impédance interne corrigée (R₀₁) à une température prédéterminée (T₀) sur la base d'une relation (Fig. 8, Fig. 15) obtenue précédemment entre l'impédance interne et la température ;
une unité de réglage de coefficient destinée à changer un coefficient (pente a) et une constante (ordonnée à l'origine b) d'une fonction SOC-OCV présentant une relation (*SOC*=*f(OCV)*) entre une tension en circuit ouvert (OCV) et l'état de charge (SOC) de la batterie (1) en fonction de l'impédance interne corrigée (R₀₁) ; et
une unité de calcul d'état de charge destinée à calculer l'état de charge (SOC) de la batterie (1) en insérant la tension en circuit ouvert (OCV) mesurée par l'unité de mesure de tension (12) dans la fonction SOC-OCV changée par l'unité de réglage de coefficient.

5. Dispositif pour détecter un état de charge d'une batterie selon la revendication 4, dans lequel la fonction SOC-OCV est une fonction linéaire.

6. Dispositif pour détecter un état de charge d'une batterie selon la revendication 5, dans lequel, lorsque l'état de charge (SOC) est y et la tension en circuit ouvert (OCV) est x, la fonction linéaire SOC-OCV est exprimée par y = ax + b (où a est le coefficient et b est la constante).

7. Dispositif pour détecter un état de charge d'une batterie selon l'une quelconque des revendications 4 à 6, dans lequel l'unité de mesure d'impédance interne (11) corrige l'impédance interne corrigée (R') de la température prédéterminée (T₀) sur la base de l'état de charge (SOC) calculé par l'unité de calcul d'état de charge afin de fournir en sortie une autre impédance interne corrigée (R").

8. Dispositif pour détecter un état de charge d'une batterie selon l'une quelconque des revendications 4 à 7, comprenant en outre un capteur de température (5) fixé à la batterie (1) pour détecter la température (T₁) de la batterie (1) afin de fournir en sortie des données de température à l'unité de mesure d'impédance interne (11).
